# EUROPÄISCHE PATENTSCHRIFT

(11) **EP 1 598 839 B1**
(45) Veröffentlichungstag und Bekanntmachung des Hinweises auf die Patenterteilung: **23.12.2015**
(21) Anmeldenummer: 05011071.7
(22) Anmeldetag: 23.05.2005
(51) Int. Cl.: H01F 27/29, H01F 17/04, H01F 19/04, H01F 27/26, H01F 27/28

(54) **Übertrager für ein Gerät der Hochfrequenztechnik, der direkt auf einer Leiterplatte angeordnet ist**
Translator for high frequency device arranged directly on a circuit board
Translateur pour dispositif à haute fréquence placé sur un circuit imprimé

(30) Priorität: 22.05.2004 DE 102004025211
(43) Veröffentlichungstag der Anmeldung: 23.11.2005
(73) Patentinhaber: Hirschmann Electronics GmbH, 72654 Neckartenzlingen (DE)
(72) Erfinder: Epple, Ralf, 73669 Lichtenwald (DE)
(74) Vertreter: Greif, Thomas

(56) Entgegenhaltungen:
- WO-A-00/42679
- DE-A1- 2 637 938
- US-A- 4 789 845
- US-A1- 2003 155 991
- US-A1- 2004 042 141

## Beschreibung

Die Erfindung betrifft einen Übertrager für ein Gerät der Hochfrequenztechnik gemäß den Merkmalen des Oberbegriffes des Patentanspruches 1.

In Geräten der Hochfrequenztechnik werden Übertrager vorzugsweise zur Impedanzanpassung und zur Energieverteilung eingesetzt. Auf Grund der Automatisierung der Bestückung von Leiterplatten der Geräte sind diese Bauteile zwecks Automatisierung und besserer Handhabbarkeit als SMD-Bauteil ausgeführt.

Ein Übertrager für ein Hochfrequenzgerät ist aus der DE 199 56 828 A1 bekannt. Dieser Übertrager weist einen Kern auf, um den ein Wickeldraht geführt ist, wobei die Enden des Wickeldrahtes mit Lötflächen verbindbar sind. Bei diesem bekannten Übertrager handelt es sich auch um ein SMD-Bauteil, bei dem der Kern des Übertragers auf einer Grundplatte angeordnet ist, die abstehende Füße aufweist, um die herum die Enden des Wickeldrahtes geführt sind und anschließend verlötet werden. Nach der Herstellung des Übertragers wird dieser als SMD-Bauteil auf der Leiterplatte des Hochfrequenz-Gerätes angeordnet und mit den abstehenden Füßen verlötet. Obwohl der Übertrager, der aus der DE 199 56 828 A1 bekannt ist, schon hinsichtlich einer Verringerung eines Abgleichaufwandes verbessert ist, ist immer noch ein nachteilig hoher Abgleichaufwand erforderlich. Außerdem bestehen konstruktive und fertigungstechnische Probleme, da z.B. der als Ferritkern ausgebildete Kern zunächst auf die Grundplatte aufgeklebt werden muss. Anschließend wird der Ferritkern mit dem Wickeldraht bewickelt. Um genügend Spannung auf die gesamte Wicklung zu bekommen, werden die Enden des Wickeldrahtes um die abstehenden Metallfüße der Grundplatte mehrmals gewickelt. Dadurch ist schon ein hoher Montageaufwand gegeben. Danach werden die Metallfüße im Lötbad verlötet, um die Enden des Wickeldrahtes festzulegen. Anschließend wird der als SMD-Bauteil gestaltete Übertrager komplett gewaschen, die Metallfüße ausgerichtet und der fertige Übertrager einer Hochfrequenz-Prüfung unterzogen. Dabei ist es auf Grund von Fertigungstoleranzen erforderlich, einen Abgleich der Wicklungslage vorzunehmen. Danach kann ein solcher Übertrager auf die Leiterplatte aufgebracht und erneut verlötet werden, wodurch die Gefahr besteht, dass sich die Lage der Wicklungsdrähte auf dem Kern verschiebt und erneut ein Abgleich erforderlich ist. Auf Grund der Zwischenanordnung der Grundplatte zwischen dem Kern und der Leiterplatte lassen sich solche Übertrager im Regelfall nur bis zu Frequenzen von 1 Gigahertz einsetzen, so dass deren Einsatzbereich bei modernen Geräten der Hochfrequenztechnik eingeschränkt ist.

Aus der US 2004/0042141 A1 oder der US 2003/0155991 A1 sind Übertrager für Hochfrequenzgeräte bekannt, die einen Kern aufweisen, wobei auf den Kern Wickeldrähte aufgewickelt sind und der fertig gestellte Übertrager als separates Bauteil auf einer Leiterplatte angeordnet ist.

Die WO 00/42679 oder die DE-US 2637938 zeigen jeweils eine Leiterplatte mit Öffnungen in der Leiterplatte und angeschlossenen Schaltdrähten.

Aus der gattungsbildenden US 4,789,845 ist ein Übertrager für ein Gerät der Hochfrequenztechnik bekannt, aufweisend eine Leiterplatte sowie einen Kern, um den zumindest ein Wickeldraht geführt ist, wobei die Enden des zumindest einen Wickeldrahtes mit Lötflächen auf der Leiterplatte verbindbar sind. Auf den Kern wird zunächst der Wickeldraht aufgebracht und der fertige Übertrager hergestellt, so dass er als fertiges separates Bauteil auf der Leiterplatte angeordnet und die Enden des Wickeldrahtes mit Lötflächen auf der Leiterplatte verbunden werden können.

Der Erfindung liegt daher die Aufgabe zu Grunde, einen Übertrager für Geräte der Hochfrequenztechnik bereitzustellen, der die eingangs geschilderten Nachteile vermeidet, der insbesondere kostengünstig als Serie herstellbar ist, der für Frequenzen oberhalb von 1 Gigahertz eingesetzt werden kann und der möglichst keinen Abgleichsaufwand erfordert.

Diese Aufgabe ist durch die Merkmale des Patentanspruches 1 gelöst. Erfindungsgemäß ist vorgesehen, dass der Kern direkt auf der Leiterplatte angeordnet ist und die Leiterplatten Öffnungen zur Durchführung der Enden des Wickeldrahtes aufweist, wobei zumindest teilweise um die Öffnung in der Leiterplatte die Lötfläche zum Verlöten der Enden des Wickeldrahtes vorgesehen ist. Damit kann der Kern vorzugsweise automatisiert auf die Leiterplatte aufgebracht und dort, insbesondere durch einen Klebevorgang, in seiner Lage fixiert werden. Anstelle einer Verklebung sind auch mechanische Festlegungen denkbar. Anschließend erfolgt das Bewickeln des Kerns mit dem Wickeldraht, wozu danach die Enden des Wickeldrahtes durch die Öffnungen in der Leiterplatte durchgeführt werden. Da um die Öffnungen die Lötfläche herum zumindest teilweise vorgesehen ist, können die Enden des Wickeldrahtes direkt an diesen Lötflächen verlötet werden, um die Wicklung auf Spannung zu halten und um einen anschließenden Abgleich zu vermeiden. Üblicherweise stehen bei dieser Bewicklung die Wickeldrähte über. Die konstruktive Ausgestaltung hat den Vorteil, daß der Draht nach dem Klemmen durch die Kante der Leiterplatte einfach abgeschert wird. Dadurch entfällt das Abschneiden der überstehenden Drähte durch ein ansonsten erforderliches Werkzeug. Durch diese konstruktive Ausgestaltung entfällt außerdem die Grundplatte eines als SMD-Bauteil ausgestalteten Übertrages, wodurch die gesamte Konstruktion wesentlich einfacher ist. Ein weiterer Vorteil besteht darin, dass die Öffnung in der Leiterplatte größer gehalten werden kann, insbesondere mit einem größeren Durchmesser, als der Wickeldraht einen Durchmesser hat. Dadurch wird der Einfädelvorgang erleichtert und es können, nachdem die Enden des Wickeldrahtes durch die Öffnungen geführt worden sind, der Wickeldraht auf Zug gehalten werden und an den Lötflächen verlötet werden. Dadurch kann der Übertrager direkt auf die Leiterplatte bewickelt werden, wobei auch dabei die Bewicklung unter mechanischer Spannung steht. Die Fügung ist sehr leicht und die Lötung wird nicht durch eine zu große Öffnung behindert. Auf diese Art und Weise sind hochfrequenztaugliche Übertrager in einem Einsatzbereich größer als 1 Gigahertz mit geringen Toleranzen herstellbar.

Weitere Ausgestaltungen der Erfindung sind in den Unteransprüchen angegeben, aus denen sich entsprechende Vorteile ergeben.

Ein Ausführungsbeispiel mit verschiedenen Detailausgestaltungen, auf die die Erfindung jedoch nicht beschränkt ist, ist im Folgenden beschrieben und anhand der Figuren erläutert.

Es zeigen:
- Figur 1:: Dreidimensionale Ansicht eines Aufbaus eines auf einer Leiterplatte angeordneten Übertragers,
- Figuren 2-4:: verschiedene Gestaltungen der Öffnung in der Leiterplatte,
- Figuren 5 und 6:: verschiedene Anordnungen mehrer Öffnungen in der Leiterplatte
- Figur 7:: eine Seitenansicht des Übertragers auf der Leiterplatte
- Figur 8:: eine weitere Gestaltung der Öffnung in der Leiterplatte

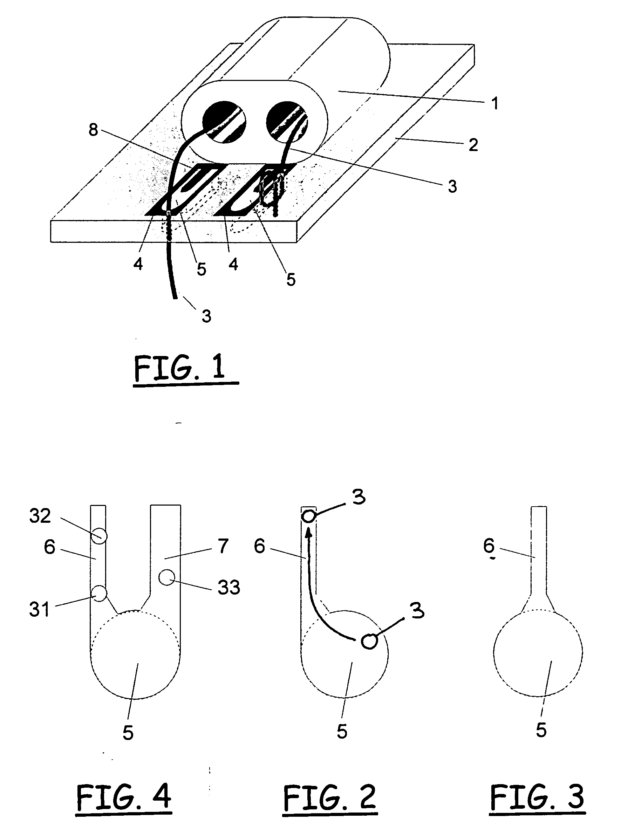

Figur 1 zeigt eine dreidimensionale Ansicht des Aufbaus eines auf einer Leiterplatte angeordneten Übertragers. Dabei ist ein Kern 1, insbesondere ein Ferritkern, auf einer Leiterplatte 2 eines nicht weiter dargestellten hochfrequenztechnischen Gerätes angeordnet. Es versteht sich von selbst, dass auf dieser Leiterplatte 2 auch weitere elektrische, elektronische Bauteile oder Steckverbindungen oder dergleichen angeordnet sind. Der Kern 1 wird mit einem Wickeldraht 3 bewickelt, was manuell oder auch vorzugsweise automatisiert erfolgen kann. In der Leiterplatte 2 sind zumindest zwei Öffnungen 4 vorgesehen, die in etwa länglich, vorzugsweise schlitzförmig, ausgebildet sind. Auf die verschiedenen Ausgestaltungen der Öffnung 4 wird in den nachfolgenden Figuren noch eingegangen. Wie in Figur 1 zu erkennen ist, weist die Öffnung 4 in der Leiterplatte 2 einen Einfädelbereich 5 auf, wobei der Einfädelbereich 5 breiter bzw. der Durchmesser größer ist, als der Durchmesser des Wickeldrahtes 3. Dadurch gestaltet sich die Durchführung der Enden des Wickeldrahtes 3 durch die Öffnung 4 besonders einfach. Weiterhin ist um die Öffnung 4 zumindest teilweise, insbesondere aber vollständig herum ein Lötbereich 6 vorhanden. Zur Herstellung des in Figur 1 gezeigten Übertragers wird der Kern 1 auf die Leiterplatte 2 gelegt, dort insbesondere durch Verkleben fixiert und anschließend der Wickeldraht 3 auf den Kern 1 gewickelt. Die Bauform des Kerns in Figur 1 ist exemplarisch, wobei Abweichungen davon oder andere Bauformen selbstverständlich auch denkbar sind und die Erfindung nicht beeinträchtigen. Nachdem die Einfädelung der Enden des Wickeldrahtes 3 im Einfädelbereich 5 erfolg ist, wobei der Einfädelbereich 5 in einer bestimmten Distanz zu dem Kern 1 vorgesehen ist, können von unten die Enden des Wickeldrahtes 3 aufgenommen und der Wickeldraht 3 unter mechanische Spannung gesetzt werden, so dass der Wickeldraht 3 in seinem Verlauf zur Anlage kommt an den Kern 1. Das gilt auch für den Verlauf des Wickeldrahtes 3 innerhalb der Öffnung 4, so dass der Draht den Einfädelbereich 5 verlässt und in Richtung des Führungsbereichs 6, der sich nahe an dem Kern 1 befindet, anlegt. Nach Abschluss dieser Vorarbeit wird der Wickeldraht 3 im Führungsbereich 6 mit der Leiterplatte 2 verbunden und dabei elektrisch kontaktiert. Nach dem Verlöten steht der Übertrager für seine Funktion zur Verfügung, ohne dass ein weiterer Abgleich erforderlich ist. Auf die verschiedenen Gestaltungen der Öffnung 4 und deren besondere Funktion wird im Folgenden eingegangen.

Die Figuren 2 bis 4 zeigen verschiedene Gestaltungen der Öffnung 4 in der Leiterplatte 2. In Figur 2 ist der Einfädelbereich 5 sowie der Führungsbereich 6 der Öffnung 4 gut zu erkennen. Dabei ist der Einfädelbereich 5 kreisförmig und der Führungsbereich 6 schlitzförmig. Der Durchmesser des Einfädelbereiches 5 (z.B. 0,8 bis 1,0 mm) ist größer als der Durchmesser des Wickeldrahtes, der z.B. einen Durchmesser im Bereich von 0,08 bis 0,2 mm aufweisen kann. Durch diesen im Durchmesser größeren Einfädelbereich 5 ist ein Durchführen des Wickeldrahtes 3 durch die Öffnung 4 ohne weiteres möglich. Ein Verkanten oder Abknicken wird dabei vermieden. Nachdem der Wickeldraht durch die zumindest beiden Öffnungen 4 durchgeführt und der Kern 1 bewickelt wurde, wird der Wickeldraht 3 angezogen, so dass er sich aus dem Einfädelbereich 5 auf Grund der Schlitzform des Führungsbereiches 6 geführt in Richtung des Kernes 1 anlegt. Dabei ist das dem Einfädelbereich 5 abgewandte Ende des schlitzförmigen Führungsbereiches 6 bis an den Kern 1 oder auch gegebenenfalls etwas unterhalb des Kernes 1 geführt. Diese Bewegung des Wickeldrahtes 1 ist durch den in Figur 2 angedeuteten Pfeil gut zu erkennen. Nachdem der Wickeldraht 3 seine in Figur 2 gezeigte Endposition (am Ende des Führungsbereiches 6) erreicht hat, wird er unter Aufrechterhaltung der mechanischen Spannung mit dem umliegenden Lötbereich (Lötfläche 8) verlötet und somit in seiner Endlage fixiert. Für den Fall, dass die Breite des Führungsbereiches 6 etwas schmaler ist als der Durchmesser des Wickeldrahtes 3, wird dieser in seiner Endlage festgeklemmt, so dass während des Lötvorganges gegebenenfalls die mechanische Spannung nicht aufrecht erhalten werden muss.

Figur 3 zeigt, dass der Schlitz, der sich von dem Einfädelbereich 5 wegstreckt, nicht tangential (wie bei Figur 2) von dem Einfädelbereich 5 ausgeht, sondern mittig.

Figur 4 zeigt eine weitere Gestaltung der Öffnung 4 in der Leiterplatte 2, wobei neben dem Führungsbereich 6 ein weiterer, vorzugsweise parallel verlaufender Schlitz 7 vorhanden ist. Durch die beiden parallel verlaufenden Schlitze ist es möglich, den Wickeldraht nicht nur in einem Schlitz durchzuführen und dort gegebenenfalls festzuklemmen und zu verlöten, sondern um die Zunge, die sich durch die beiden Schlitze bildet, herumzuführen, was durch die Wickeldrahtabschnitte 31, 32 und 33 angedeutet ist. Auf diese Art und Weise kann der Wickeldraht 3 zusätzlich festgelegt und unter mechanische Vorspannung gebracht werden. Danach wird dieser etwa spiralförmige Bereich der Wickeldrahtabschnitt 31 bis 33 möglichst nahe an den Kern 1 herangedrückt und anschließend verlötet. Das Einbringen sowohl des Einfädelbereiches 5 als auch der Schlitze kann z.B. durch ein Werkzeug (insbesondere ein Bohrer für den Einfädelbereich 5) oder auch mit einem Laser (insbesondere für die Schlitze) erfolgen. Dabei sind die Schlitze, wie schon ausgeführt, so bemessen, dass sie den Wickeldraht 3 bzw. die betreffenden Wickeldrahtabschnitte 31 bis 33 fest fixieren können, indem der Wickeldraht 3 während des Einfädelns nach unten von der Leiterplatte 2 weg wieder zum Kern 1 hin gezogen wird.

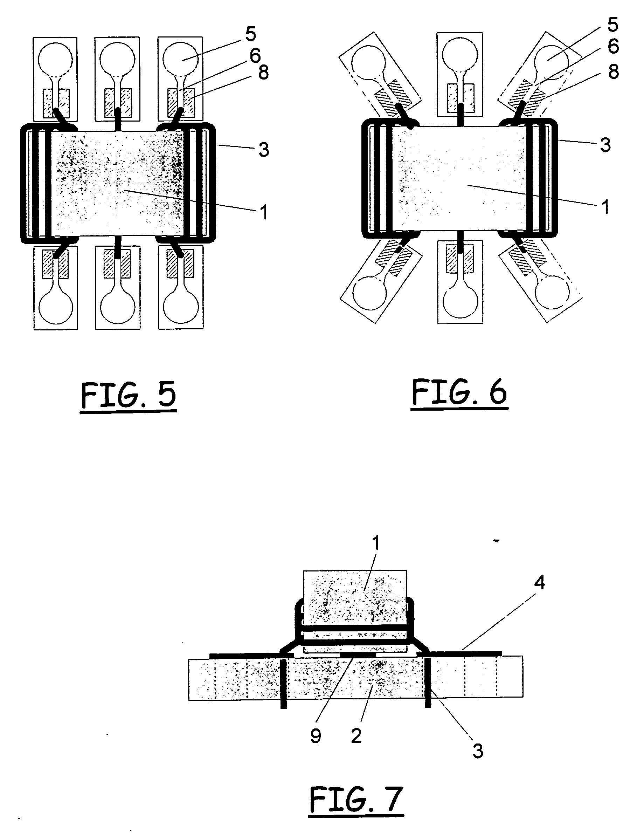

Die Figuren 5 und 6 zeigen verschiedene Anordnungen mehrerer Öffnungen 4 in der Leiterplatte 2. Je nach Bauweise und Einsatzzweck kann der Übertrager mehrere Wicklungen aufweisen, wozu auch mehrere Öffnungen erforderlich sind. Dabei sind diese mehreren Öffnungen 4 z.B. reihenförmig und parallel zu dem Kern 1 angeordnet, wie es in Figur 5 dargestellt ist, oder in etwa konzentrisch zu dem Kern 1 angeordnet, wobei die konzentrische Anordnung insbesondere bei einem Kern Anwendung findet, der einen runden Querschnitt aufweist. Eine solche Anordnung der Öffnungen 4 in konzentrischer Form ist in Figur 6 dargestellt. Bei den Figuren 5 und 6 ist auch noch einmal gut zu erkennen, wie die Öffnung 4 gestaltet und die Lage des Wicklungsdrahtes 3 nach dem Einfädeln und Verlöten innerhalb der Lötfläche 8 ist. Dazu wird noch einmal auf die Ausgestaltung der Öffnung 4 verwiesen, wie sie z.B. in Figur 3 dargestellt ist, dass nämlich der Einfädelbereich 5 beabstandet ist von dem Führungsbereich (Schlitz) 6 (und wenn vorhanden, dem Schlitz 7), so dass der Wickeldraht 3 in seiner endgültigen Position nahe an dem Kern 1 angeordnet ist.

Figur 7 zeigt eine Seitenansicht des Übertragers auf der Leiterplatte 2, wobei noch einmal die endgültige Lage des Wickeldrahtes 3 gezeigt ist, nachdem er eingefädelt und unter mechanischer Spannung verlötet wurde. Zur Lagefixierung des Kerns 1 auf der Leiterplatte 2 ist ein Klebebereich 9 vorhanden, der beispielsweise als Doppelklebeband, Zwei- oder Mehrkomponentenkleber oder dergleichen ausgebildet ist. Auf Grund des Klebebereiches 9 ist die Bauform des Kerns 1 nicht mehr von entscheidender Bedeutung, wobei allerdings nach wie vor eine Bauform des Kerns 1 zu bevorzugen ist, die in Richtung der Leiterplatte 2 eine abgeflachte Stelle aufweist, um die Lagefixierung zu vereinfachen.

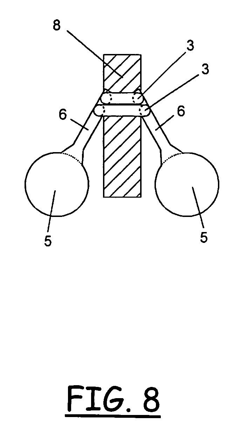

Figur 8 schließlich zeigt eine weitere Gestaltung der Öffnung in der Leiterplatte (die hier nicht dargestellt ist). Bei dieser Gestaltung sind zwei Einfädelbereiche 5 vorhanden, die einen größeren Durchmesser haben als der Führungsbereich 6 breit ist. Dadurch kann in besonders vorteilhafter Weise der Wickeldraht 3 (hier punktiert dargestellt) um die Lötfläche 8 (hier schraffiert dargestellt) gewickelt werden.

### Bezugszeichenliste:

- 1.: Kern (Ferritkern)
- 2.: Leiterplatte
- 3.: Wickeldraht
- 31.: Wickeldrahtlabschnitt
- 32.: Wickeldrahtlabschnitt
- 33.: Wickeldrahtlabschnitt
- 4.: Öffnung
- 5.: Einfädelbereich
- 6.: Führungsbereich
- 7.: Schlitz
- 8.: Lötfläche
- 9.: Klebebereich

## Patentansprüche

1. Übertrager für ein Gerät der Hochfrequenztechnik mit einer Leiterplatte (2) sowie mit einem Kern (1), um den zumindest ein Wickeldraht (3) geführt Ist, wobei die Enden des zumindest einen Wickeldrahtes (3) mit Lötflächen (8) auf der Leiterplatte (2) verbindbar sind, wobei der Kern (1) direkt auf der Leiterplatte (2) angeordnet ist und die Leiterplatte (2) Öffnungen (4) zur Durchführung der Enden des zumindest einen Wickeldrahtes (3) aufweist, wobei zumindest teilweise um die Öffnungen (4) die Lötflächen (8) zum Verlöten der Enden des Wickeldrahtes (3) vorgesehen sind, **dadurch gekennzeichnet, dass** die Öffnungen (4) einen Einfädeibereich (5) für die Enden des Wickeldrahtes (3) sowie einen Führungsbereich (6) aufweisen, um nach dem Anordnen des Kernes (1) auf der Leiterplatte (2) das Bewicklen des Kernes (1) mit dem Wickeldraht (3) durchführen zu können.

2. Übertrager nach Anspruch 1, **dadurch gekennzeichnet, dass** der Einfädelbereich (5) größer ist als der Führungsbereich (6), vorzugsweise einen größeren Durchmesser aufweist als der Führungsbereich (6) breit ist.

3. Übertrager nach einem der vorhergehenden Ansprüche, **dadurch gekennzeichnet, dass** die Öffnung (4) im Einfädelbereich (5) rund und im Führungsbereich (6) schlitzförmig ausgebildet ist.

4. Übertrager nach einem der vorhergehenden Ansprüche, **dadurch gekennzeichnet, dass** die Öffnung (4) neben dem Führungsbereich (6) zumindest einen weiteren Führungsbereich, insbesondere einen Schlitz (7), aufweist.

5. Übertrager nach einem der vorhergehenden Ansprüche, **dadurch gekennzeichnet, dass** mehrere Öffnungen (4) um den Kern (1) herum angeordnet sind.

6. Übertrager nach Anspruch 6, **dadurch gekennzeichnet, dass** die mehreren Öffnungen (4) konzentrisch oder reihenförmig um den Kern (1) angeordnet sind.

7. Übertrager nach einem der vorhergehenden Ansprüche, **dadurch gekennzeichnet, dass** der Kern (1) auf der Leiterplatte (2) aufgeklebt ist.

## Claims

1. Transformer for a radio-frequency device having a printed circuit board (2) and also having a core (1) around which at least one winding wire (3) is passed, wherein the ends of the at least one winding wire (3) can be connected to solder areas (8) on the printed circuit board (2), wherein the core (1) is arranged directly on the printed circuit board (2) and the printed circuit board (2) has openings (4) through which the ends of the at least one winding wire (3) are passed, wherein the solder areas (8) for soldering the ends of the winding wire (3) are provided at least partially around the openings (4), **characterized in that** the openings (4) have an insertion region (5) for the ends of the winding wire (3) and also a guide region (6) in order to be able to wind the winding wire (3) around the core (1) after the core (1) is arranged on the printed circuit board (2).

2. Transformer according to Claim 1, **characterized in that** the insertion region (5) is larger than the guide region (6), preferably has a diameter which is larger than the width of the guide region (6).

3. Transformer according to either of the preceding claims, **characterized in that** the opening (4) is round in the insertion region (5) and in the form of a slot in the guide region (6).

4. Transformer according to one of the preceding claims, **characterized in that** the opening (4) has at least one further guide region, in particular a slot (7), next to the guide region (6).

5. Transformer according to one of the preceding claims, **characterized in that** a plurality of openings (4) are arranged around the core (1).

6. Transformer according to Claim 5, **characterized in that** the plurality of openings (4) are arranged concentrically or in rows around the core (1).

7. Transformer according to one of the preceding claims, **characterized in that** the core (1) is adhesively bonded on the printed circuit board (2).

## Revendications

1. Translateur pour un appareil à haute fréquence avec un circuit imprimé (2) ainsi qu'avec un coeur (1) autour duquel l'au moins un fil de bobine (3) est guidé, les extrémités de l'au moins un fil de bobine (3) peuvent être reliées aux surfaces de brasage (8) sur le circuit imprimé (2), le coeur (1) étant disposé directement sur le circuit imprimé (2) et le circuit imprimé (2) comportant des ouvertures (4) pour réaliser les extrémités de l'au moins un fil de bobine (3), les surfaces de brasage (8) étant prévues au moins en partie autour des ouvertures (4) pour braser les extrémités du fil de bobine (3), **caractérisé en ce que** les ouvertures (4) comportent une zone d'enfilage (5) pour les extrémités du fil de bobine (3) ainsi qu'une zone de guidage (6) permettant de réaliser, après la mise en place du coeur (1) sur le circuit imprimé (2), l'enroulement du coeur (1) avec le fil de bobine (3).

2. Translateur selon la revendication 1, **caractérisé en ce que** la zone d'enfilage (5) est plus grande que la zone de guidage (6), comporte de préférence un plus grand diamètre que la largeur de la zone de guidage (6).

3. Translateur selon l'une quelconque des revendications précédentes, **caractérisé en ce que** l'ouverture (4) prend une forme ronde dans la zone d'enfilage (5) et une forme fendue dans la zone de guidage (6).

4. Translateur selon l'une quelconque des revendications précédentes, **caractérisé en ce que** l'ouverture (4) comporte à côté de la zone de guidage (6) au moins une zone de guidage supplémentaire, notamment une fente (7).

5. Translateur selon l'une quelconque des revendications précédentes, **caractérisé en ce que** plusieurs ouvertures (4) sont disposées autour du coeur (1).

6. Translateur selon la revendication 5, **caractérisé en ce que** les plusieurs ouvertures (4) sont disposées concentriquement ou en forme de rangée autour du coeur (1).

7. Translateur selon l'une quelconque des revendications précédentes, **caractérisé en ce que** le coeur (1) est collé sur le circuit imprimé (2).
